# EUROPEAN PATENT APPLICATION

(11) **EP 1 675 163 A2**
(43) Date of publication of application: **28.06.2006**
(21) Application number: 05028009.8
(22) Date of filing: 21.12.2005
(51) Int. Cl.: H01L 21/02, H01L 27/115

(54) **Ferroelectric film and method of manufacturing the same**

(30) Priority: 27.12.2004 JP 2004376702
(71) Applicant: SEIKO EPSON CORPORATION, Shinjuku-ku, Tokyo 163-0811 (JP)
(72) Inventor: Kijima, Takeshi, Suwa-shi Nagano-ken 392-8502 (JP); Hamada, Yasuaki, Suwa-shi Nagano-ken 392-8502 (JP); Kobayashi, Tomokazu, Suwa-shi Nagano-ken 392-8502 (JP)
(74) Representative: Hoffmann, Eckart

(57) **Abstract**

A method of manufacturing a ferroelectric film including: (a) mixing a polycarboxylate containing niobium, a polycarboxylate containing bismuth, a polycarboxylic acid or a polycarboxylic acid ester, and an organic solvent; and (b) applying the resulting mixed solution to a substrate and heat-treating the applied mixed solution to form a ferroelectric film including BiNbO₄.

## Description

### BACKGROUND OF THE INVENTION

The present invention relates to a ferroelectric film and a method of manufacturing the same.

A ferroelectric such as PZT has been used for various applications such as a ferroelectric memory, a piezoelectric device, and an infrared sensor, and has been extensively researched and developed.

In particular, the ferroelectric memory is nonvolatile and is expected to serve as a next-generation memory having an operation speed equal to the operation speed of a DRAM. Moreover, the ferroelectric memory consumes a small amount of power in comparison with other memories.

However, since a ferroelectric material such as PZT contains a large amount of lead which is harmful to the human body, it is not desirable to mass-produce such a ferroelectric material. Moreover, since lead contained in PZT easily volatilizes, oxygen deficiency tends to occur due to low bonding energy with lead.

### SUMMARY

According to a first aspect of the invention, there is provided a ferroelectric film, comprising BiNbO₄.

According to a second aspect of the invention, there is provided a method of manufacturing a ferroelectric film, the method comprising:
(a) mixing a polycarboxylate containing niobium, a polycarboxylate containing bismuth, a polycarboxylic acid or a polycarboxylic acid ester, and an organic solvent; and
(b) applying the resulting mixed solution to a substrate and heat-treating the applied mixed solution to form a ferroelectric film including BiNbO₄.

According to a third aspect of the invention, there is provided a method of manufacturing a ferroelectric film, the method comprising:
(a) mixing a sol-gel raw material including a hydrolysis-condensation product of a metal alkoxide containing niobium, a sol-gel raw material including a hydrolysis-condensation product of a metal alkoxide containing bismuth, a polycarboxylic acid or a polycarboxylic acid ester, and an organic solvent, and causing the polycarboxylic acid or a polycarboxylic acid derived from the polycarboxylic acid ester to undergo esterification with the metal alkoxide containing niobium and the metal alkoxide containing bismuth to prepare a ferroelectric precursor composition; and
(b) applying the precursor composition to a substrate and heat-treating the applied precursor composition to form a ferroelectric film including BiNbO₄.

According to a fourth aspect of the invention, there is provided a ferroelectric raw material solution, comprising:
a polycarboxylate containing niobium;
a polycarboxylate containing bismuth;
a polycarboxylic acid or a polycarboxylic acid ester; and
an organic solvent.

According to a fifth aspect of the invention, there is provided a ferroelectric raw material solution, comprising:
a sol-gel raw material including a hydrolysis-condensation product of a metal alkoxide containing niobium;
a sol-gel raw material including a hydrolysis-condensation product of a metal alkoxide containing bismuth;
a polycarboxylic acid or a polycarboxylic acid ester; and
an organic solvent.

According to a sixth aspect of the invention, there is provided a ferroelectric capacitor, comprising a ferroelectric film including BiNbO₄.

According to a seventh aspect of the invention, there is provided a ferroelectric memory, comprising a ferroelectric film including BiNb0₄.

### BRIEF DESCRIPTION OF THE SEVERAL VIEWS OF THE DRAWING

FIG. 1 is a cross-sectional diagram showing a ferroelectric capacitor according to one embodiment of the invention.

FIG. 2 is a diagram illustrative of a Bi-layered perovskite type crystal structure.

FIG. 3 is a diagram showing niobium octylate used in one embodiment of the invention.

FIGS. 4A and 4B are respectively a plan view and a cross-sectional diagram schematically showing a simple matrix type ferroelectric memory device according to one embodiment of the invention.

FIG. 5 is a cross-sectional diagram showing an example of a ferroelectric memory device according to one embodiment of the invention in which a memory cell array and a peripheral circuit are integrated on a single substrate.

FIGS. 6A and 6B are respectively a cross-sectional diagram and an equivalent circuit diagram schematically showing a 1T1C type ferroelectric memory according to a modification of one embodiment of the invention.

FIG. 7 shows a sample formation method in an experimental example according to one embodiment of the invention.

FIG. 8 shows crystallinity of a ferroelectric film sample in the experimental example.

FIG. 9 shows hysteresis characteristics of a sample in the experimental example.

### DETAILED DESCRIPTION OF THE EMBODIMENT

The invention may provide a ferroelectric film which does not contain lead and exhibits high reliability, a method of manufacturing the same, a ferroelectric capacitor, and a ferroelectric memory.

According to one embodiment of the invention, there is provided a ferroelectric film, comprising BiNb0₄.

In this ferroelectric film, the BiNbO₄ may have a Bi-layered perovskite structure.

This ferroelectric film may further comprise Si or Si and Ge.

According to one embodiment of the invention, there is provided a method of manufacturing a ferroelectric film, the method comprising:
(a) mixing a polycarboxylate containing niobium, a polycarboxylate containing bismuth, a polycarboxylic acid or a polycarboxylic acid ester, and an organic solvent; and
(b) applying the resulting mixed solution to a substrate and heat-treating the applied mixed solution to form a ferroelectric film including BiNbO₄.

According to one embodiment of the invention, there is provided a method of manufacturing a ferroelectric film, the method comprising:
(a) mixing a sol-gel raw material including a hydrolysis-condensation product of a metal alkoxide containing niobium, a sol-gel raw material including a hydrolysis-condensation product of a metal alkoxide containing bismuth, a polycarboxylic acid or a polycarboxylic acid ester, and an organic solvent, and causing the polycarboxylic acid or a polycarboxylic acid derived from the polycarboxylic acid ester to undergo esterification with the metal alkoxide containing niobium and the metal alkoxide containing bismuth to prepare a ferroelectric precursor composition; and
(b) applying the precursor composition to a substrate and heat-treating the applied precursor composition to form a ferroelectric film including BiNb0₄.

In the above methods of manufacturing a ferroelectric film, the organic solvent may be an alcohol.

In the above methods of manufacturing a ferroelectric film, the step (a) may include mixing a sol-gel raw material containing Si or Si and Ge. It is preferable to add Si or Si and Ge to the precursor composition in an amount of 1 to 3 mol%.

According to one embodiment of the invention, there is provided a ferroelectric raw material solution, comprising:
a polycarboxylate containing niobium;
a polycarboxylate containing bismuth;
a polycarboxylic acid or a polycarboxylic acid ester; and
an organic solvent.

According to one embodiment of the invention, there is provided a ferroelectric raw material solution, comprising:
a sol-gel raw material including a hydrolysis-condensation product of a metal alkoxide containing niobium;
a sol-gel raw material including a hydrolysis-condensation product of a metal alkoxide containing bismuth;
a polycarboxylic acid or a polycarboxylic acid ester; and
an organic solvent.

According to one embodiment of the invention, there is provided a ferroelectric capacitor, comprising a ferroelectric film including BiNbO₄.

According to one embodiment of the invention, there is provided a ferroelectric memory, comprising a ferroelectric film including BiNb0₄.

These embodiments of the invention will be described in detail below, with reference to the drawings.

### 1. Ferroelectric film and ferroelectric capacitor

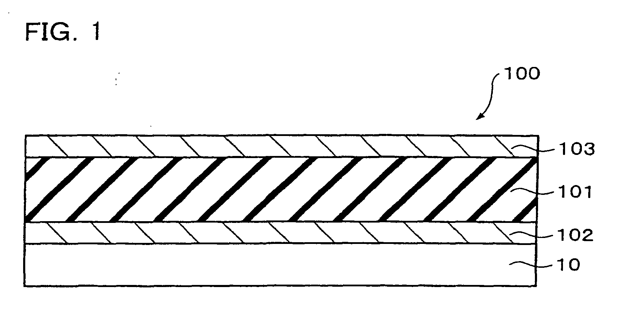

FIG. 1 is a cross-sectional diagram schematically showing a ferroelectric capacitor 100 using a ferroelectric film 101 according to one embodiment of the invention.

As shown in FIG. 1, the ferroelectric capacitor 100 includes a substrate 10, a first electrode 102, the ferroelectric film 101 formed on the first electrode 102, and a second electrode 103 formed on the ferroelectric film 101.

The thicknesses of the first electrode 102 and the second electrode 103 are about 50 to 150 nm, for example.

The ferroelectric film 101 includes BiNbO₄ and has a Bi-layered perovskite structure. The ferroelectric film 101 further includes Si or Si and Ge. The addition of Si or Si and Ge is described later.

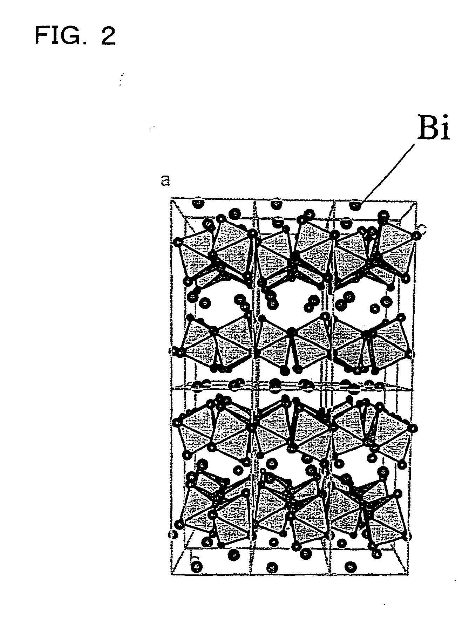

A Bi-layered perovskite has a crystal structure as shown in FIG 2. A plurality of octahedrons having oxygen at the vertices are disposed between layers formed by Bi. Nb is positioned inside the octahedron. The ferroelectric film 101 according to one embodiment of the invention includes a-phase (ferroelectric phase) BiNbO₄. The thickness of the ferroelectric film 101 is about 50 to 150 nm, for example.

### 2. Method of manufacturing ferroelectric film and ferroelectric capacitor

A method of manufacturing a ferroelectric film and a ferroelectric capacitor according to one embodiment of the invention is described below.

The substrate 10 is provided. As the material for the substrate 10, silicon or the like may be used.

The first electrode 102 is formed on the substrate 10. The first electrode 102 may be formed by using a laser ablation method, for example. Specifically, a target containing a desired electrode material is provided. Then, atoms including an oxygen atom and a metal atom are scattered from the target by applying laser light to the target to cause a plume to occur. The plume is emitted toward the substrate 10 and caused to come in contact with the substrate 10. As a result, the first electrode 102 is epitaxially grown on the substrate 10.

The material for the first electrode 102 is not particularly limited. For example, Pt, Ir, IrOₓ, SrRuO₃, Nb-SrTiO₃, La-SrTiO₃, Nb-(La,Sr)CoO₃, LaNiO₃, PbBaO₃, or the like may be used. Nb-SrTiO₃ is obtained by doping SrTiO₃ with Nb, La-SrTiO₃ is obtained by doping SrTiO₃ with La, and Nb-(La,Sr)CoO₃ is obtained by doping (La,Sr)CoO₃ with Nb.

As the formation method for the first electrode 102, an ion beam assist method, a sputtering method, a vacuum deposition method, or the like may be used instead of the laser ablation method.

Then, the ferroelectric film 101 is formed on the first electrode 102.

A polycarboxylate containing niobium, a polycarboxylate containing bismuth, a polycarboxylic acid or a polycarboxylic acid ester, and an organic solvent are mixed.

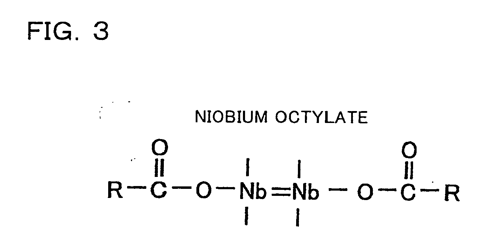

As the polycarboxylate containing niobium, niobium octylate or the like may be used. As shown in the FIG. 3, niobium octylate has a structure in which two Nb atoms form a covalent bond and an octyl group exists in the remaining site.

The network formation between the polycarboxylic acid and niobium octylate proceeds mainly by an alcohol exchange reaction. Specifically, a reaction occurs between the carboxylic acid and the octyl group (alcohol exchange reaction) so that esterification (R-COO-Nb) proceeds. According to one embodiment of the invention, the molecule of niobium octylate can be bonded to the precursor network by condensation between niobium octylate and an alkoxide by esterifying niobium octylate.

As the polycarboxylate containing bismuth, bismuth octylate or the like may be used. The network formation of bismuth octylate proceeds mainly by an alcohol exchange reaction in the same manner as niobium octylate.

As the organic solvent used in one embodiment of the invention, an alcohol may be used. A sol-gel raw material and the polycarboxylic acid or the polycarboxylic acid ester can be efficiently dissolved by using an alcohol as the solvent.

The alcohol is not particularly limited. As examples of the alcohol, monohydric alcohols such as butanol, methanol, ethanol, and propanol, and polyhydric alcohols can be given. Specific examples of such an alcohol are given below.

### Monohydric alcohol:

Propanol (propyl alcohol): 1-propanol (boiling point: 97.4°C) and 2-propanol (boiling point:82.7°C)
Butanol (butyl alcohol): 1-butanol (boiling point: 117°C), 2-butanol (boiling point: 100°C), 2-methyl-1-propanol (boiling point: 108°C), and 2-methyl-2-propanol (melting point: 25.4°C, boiling point: 83°C)
Pentanol (amyl alcohol): 1-pentanol (boiling point: 137°C), 3-methyl-l-butanol (boiling point: 131°C), 2-methyl-l-butanol (boiling point: 128°C), 2,2-dimethyl-l-propanol (boiling point: 113°C), 2-pentanol (boiling point: 119°C), 3-methyl-2-butanol (boiling point: 112.5°C), 3-pentanol (boiling point: 117°C), and 2-methyl-2-butanol (boiling point: 102°C)

### Polyhydric alcohol:

Ethylene glycol (melting point: -11.5°C, boiling point: 197.5°C) and glycerol (melting point: 17°C, boiling point: 290°C)

It is preferable that the polycarboxylic acid or the polycarboxylic acid ester be a dicarboxylic acid or a dicarboxylic acid ester.

As examples of the polycarboxylic acid, the following compounds can be given. As examples of a tricarboxylic acid, trans-aconitic acid, trimesic acid, and the like can be given. As examples of a tetracarboxylic acid, pyromellitic acid, 1,2,3,4-cyclopentanetetracarboxylic acid, and the like are can be given. As examples of a polycarboxylic acid ester which dissociates in an alcohol and functions as a polycarboxylic acid, dicarboxylic acid esters such as dimethyl succinate, diethyl succinate, dibutyl oxalate, dimethyl malonate, dimethyl adipate, dimethyl maleate, and diethyl fumarate, tricarboxylic acid esters such as tributyl citrate and triethyl 1,1,2-ethanetricarboxylate, tetracarboxylic acid esters such as tetraethyl 1,1,2,2-ethanetetracarboxylate and trimethyl 1,2,4-benzenetricarboxylate, and the like can be given. These polycarboxylic acid esters dissociate in the presence of an alcohol and function as polycarboxylic acids. A feature of one embodiment of the invention is that the network is grown by esterification using the polycarboxylic acid. Since the ester network is not grown when using a monocarboxylic acid or a monocarboxylic acid ester, such as acetic acid or methyl acetate, a monocarboxylic acid or a monocarboxylic acid ester is not used in one embodiment of the invention.

The dicarboxylic acid ester may be preferably at least one ester selected from a succinic acid ester, a maleic acid ester, and a malonic acid ester. As specific examples of these esters, dimethyl succinate, dimethyl maleate, and dimethyl malonate can be given.

In the method of manufacturing a ferroelectric film according to one embodiment of the invention, a sol-gel raw material containing Si or Si and Ge may be used as a sol-gel raw material including a hydrolysis-condensation product of a metal alkoxide. As such a sol-gel solution, a PbSiO₃ sol-gel solution or a combination of a PbSiO₃ sol-gel solution and a PbGeO₃ sol-gel solution may be used. The deposition temperature can be reduced by using a sol-gel raw material containing Si or Ge, so that a ferroelectric can be crystallized at about 450°C.

Alpha (a)-phase (ferroelectric phase) BiNbO₄ can be more reliably obtained by adding Si or Si and Ge.

The ferroelectric film 101 may be formed by applying the mixed solution to the substrate and crystallizing the applied solution by heat treatment or the like.

In more detail, a series of steps consisting of a mixed solution coating step, an alcohol removal step, a drying heat treatment step, and a cleaning heat treatment step is performed a desired number of times, and the resulting product is sintered by crystallization annealing to form the ferroelectric film 101. The conditions in each step are as follows.

The mixed solution coating step is performed by applying the mixed solution by using a coating method such as spin coating. First, the mixed solution is applied dropwise to the first electrode 102. A spin operation is performed in order to spread the applied solution over the entire surface of the substrate. The rotational speed of the spin operation is set at about 500 rpm, for example. Then, the spin operation is performed at a lower rotational speed for a desired period of time so that the first electrode 102 is coated with the mixed solution. The rotational speed of this spin operation is set at 50 rpm or less, for example. The drying heat treatment step is performed at 150 to 180°C. The drying heat treatment is performed in air by using a hot plate or the like. The cleaning heat treatment step is performed in air on a hot plate maintained at 300 to 350°C. The crystallization sintering step is performed in an oxygen atmosphere by rapid thermal annealing (RTA) or the like.

The thickness of the ferroelectric film 101 after sintering may be about 50 to 150 nm. The ferroelectric film 101 may be formed by using a sputtering method, a molecular beam epitaxy method, a laser ablation method, or the like.

A sol-gel raw material including a hydrolysis-condensation product of a metal alkoxide containing niobium and a sol-gel raw material including a hydrolysis-condensation product of a metal alkoxide containing bismuth may be used instead of the polycarboxylate containing niobium and the polycarboxylate containing bismuth. A ferroelectric precursor composition may be prepared by mixing the sol-gel raw material including a hydrolysis-condensation product of a metal alkoxide containing niobium, the sol-gel raw material including a hydrolysis-condensation product of a metal alkoxide containing bismuth, the polycarboxylic acid or the polycarboxylic acid ester, and the organic solvent, and causing the polycarboxylic acid or a polycarboxylic acid derived from polycarboxylic acid ester to undergo esterification with the metal alkoxide containing niobium and the metal alkoxide containing bismuth.

The formation reaction of the precursor composition is roughly divided into a first-stage alkoxy group substitution reaction and a second-stage polymer network formation reaction by esterification.

In the first-stage reaction, dimethyl succinate and the metal alkoxide of the sol-gel raw material are esterified to form an ester bond. Specifically, dimethyl succinate dissociates in n-butanol so that one of the carbonyl groups (first carbonyl group) is protonated. A substitution reaction occurs between the first carbonyl group and the alkoxy group of the metal alkoxide so that a reaction product, in which the first carboxyl group is esterified, and an alcohol are produced. The "ester bond" used herein means a bond (-COO-) formed by a carbonyl group and an oxygen atom.

In the second-stage reaction, a substitution reaction occurs between the other carboxyl group (second carboxyl group), which remained unreacted in the first-stage reaction, and the alkoxy group of the metal alkoxide so that a reaction product, in which the second carboxyl group is esterified, and an alcohol are produced.

A polymer network in which the hydrolysis-condensation products of the metal alkoxide contained in the sol-gel raw material are bonded through ester bonds is obtained by the above two-stage reaction. Therefore, this polymer network contains a moderate amount of ester bond in the network.

Then, the second electrode 103 is formed on the ferroelectric film 101. The second electrode 103 may be formed by using a sputtering method, a vacuum deposition method, or the like. It is preferable to use a material mainly containing Pt for the upper electrode. The material for the second electrode 103 is not limited to Pt. A known electrode material such as Ir, IrOₓ, SrRuO₃, Nb-SrTiO₃, La-SrTiO₃, Nb-(La,Sr)CoO₃, LaNiO₃, or PbBaO₃ may also be used.

Then, post annealing may optionally be performed in an oxygen atmosphere by RTA or the like. This enables an excellent interface to be formed between the second electrode 103 and the ferroelectric film 101 and improves the crystallinity of the ferroelectric film 101.

The ferroelectric film 101 and the ferroelectric capacitor 100 according to one embodiment of the invention can be manufactured by the above-described steps.

According to the ferroelectric capacitor 100 of one embodiment of the invention, the crystallization temperature can be reduced and the hysteresis squareness can be improved. An improvement of the hysteresis squareness by the ferroelectric capacitor 100 has an effect on stability against a disturbance, which is important for driving a simple matrix type ferroelectric memory device.

### 3. Ferroelectric memory

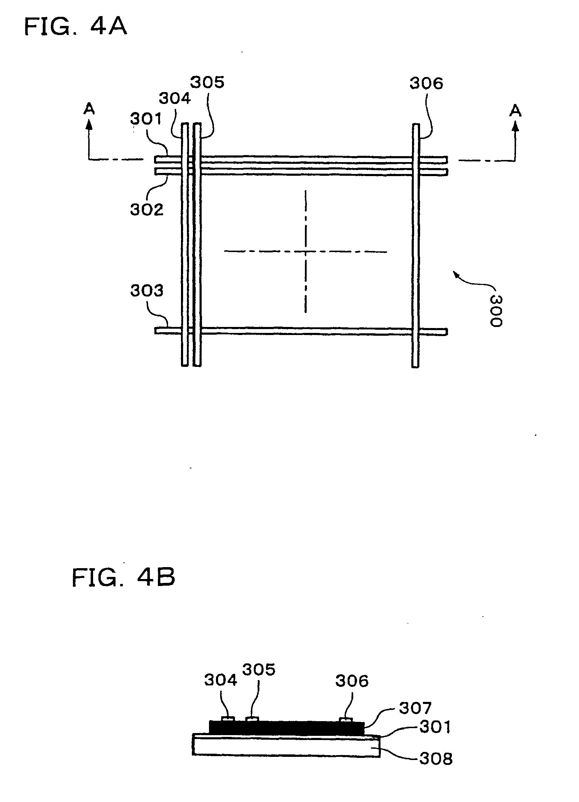

FIGS. 4A and 4B are diagrams showing a configuration of a simple matrix type ferroelectric memory device 300 according to one embodiment of the invention. FIG. 4A is a plan view of the ferroelectric memory device 300, and FIG. 4B is a cross-sectional diagram along the line A-A shown in FIG 4A. As shown in FIGS. 4A and 4B, the ferroelectric memory device 300 includes a specific number of wordlines 301 to 303 formed on a substrate 308, and a specific number of bitlines 304 to 306. A ferroelectric film 307 described in the above-described embodiment is inserted between the wordlines 301 to 303 and the bitlines 304 to 306, so that ferroelectric capacitors are formed at the intersecting regions of the wordlines 301 to 303 and the bitlines 304 to 306.

In the ferroelectric memory device 300 in which memory cells are arranged in a simple matrix, data is written into or read from the ferroelectric capacitors formed in the intersecting regions of the wordlines 301 to 303 and the bitlines 304 to 306 by using a peripheral driver circuit, a read amplifier circuit, and the like (not shown) (hereinafter collectively called "peripheral circuit"). The peripheral circuit may be formed by forming MOS transistors on a substrate differing from the substrate of the memory cell array and connecting the MOS transistors with the wordlines 301 to 303 and the bitlines 304 to 306. Or, the peripheral circuit and the memory cell array may be integrated on a single substrate by using a single-crystal silicon substrate as the substrate 308.

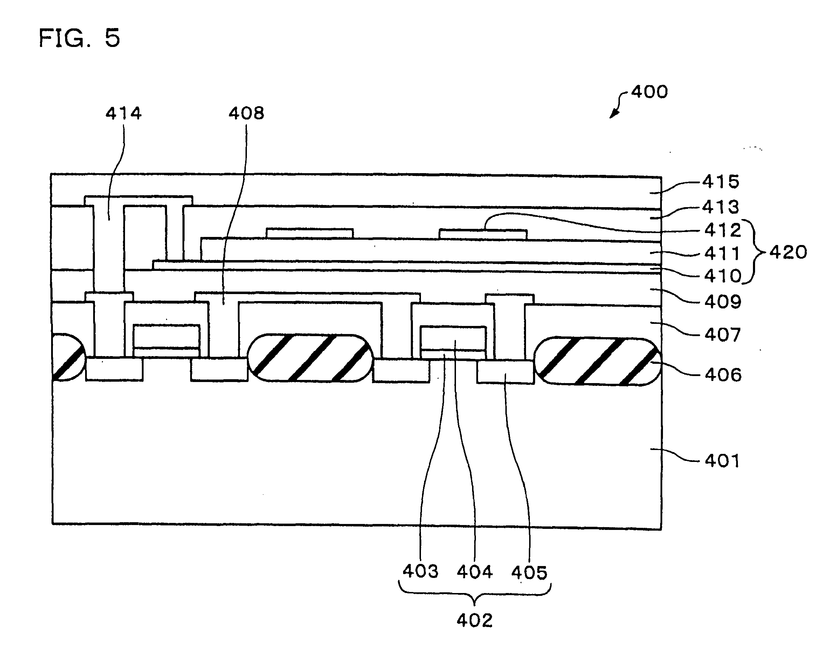

FIG. 5 is a cross-sectional diagram showing an example of a ferroelectric memory device 400 according to one embodiment of the invention in which a memory cell array and a peripheral circuit are integrated on a single substrate.

In FIG. 5, MOS transistors 402 are formed on a single-crystal silicon substrate 401, and the transistor formation region corresponds to a peripheral circuit section. The MOS transistor 402 is formed by the single-crystal silicon substrate 401, source/drain regions 405, a gate insulating film 403, and a gate electrode 404. The ferroelectric memory device 400 includes an element isolation oxide film 406, a first interlayer dielectric 407, a first interconnect layer 408, and a second interlayer dielectric 409.

The ferroelectric memory device 400 includes a memory cell array including ferroelectric capacitors 420. The ferroelectric capacitor 420 includes a lower electrode 410 (first electrode or second electrode) functioning as a wordline or a bitline, a ferroelectric film 411 including a ferroelectric phase and a paraelectric phase, and an upper electrode 412 (second electrode or first electrode) formed on the ferroelectric film 411 and functioning as the bitline or the wordline.

The ferroelectric memory device 400 includes a third interlayer dielectric 413 over the ferroelectric capacitor 420. The memory cell array is connected with the peripheral circuit section through a second interconnection layer 414. In the ferroelectric memory device 400, a protective film 415 is formed over the third interlayer dielectric 413 and the second interconnect layer 414.

According to the ferroelectric memory device 400 having the above-described configuration, the memory cell array and the peripheral circuit section can be integrated on a single substrate. The ferroelectric memory device 400 shown in FIG 5 has a configuration in which the memory cell array is formed over the peripheral circuit section. However, the ferroelectric memory device 400 may have a configuration in which the memory cell array is not disposed over the peripheral circuit section and is adjacent to the peripheral circuit section in the horizontal direction.

Since the ferroelectric capacitor 420 used in one embodiment of the invention includes the ferroelectric film according to the above-described embodiment, the ferroelectric capacitor 420 exhibits excellent hysteresis squareness and has stable disturbance characteristics. Moreover, since the ferroelectric capacitor 420 allows a decrease in process temperature, damage to the peripheral circuit and other elements is reduced. Furthermore, since process damage (particularly reduction by hydrogen) occurs to only a small extent, hysteresis deterioration due to damage can be prevented. Therefore, the simple matrix type ferroelectric memory device 300 can be put into practical use by using the ferroelectric capacitor 420.

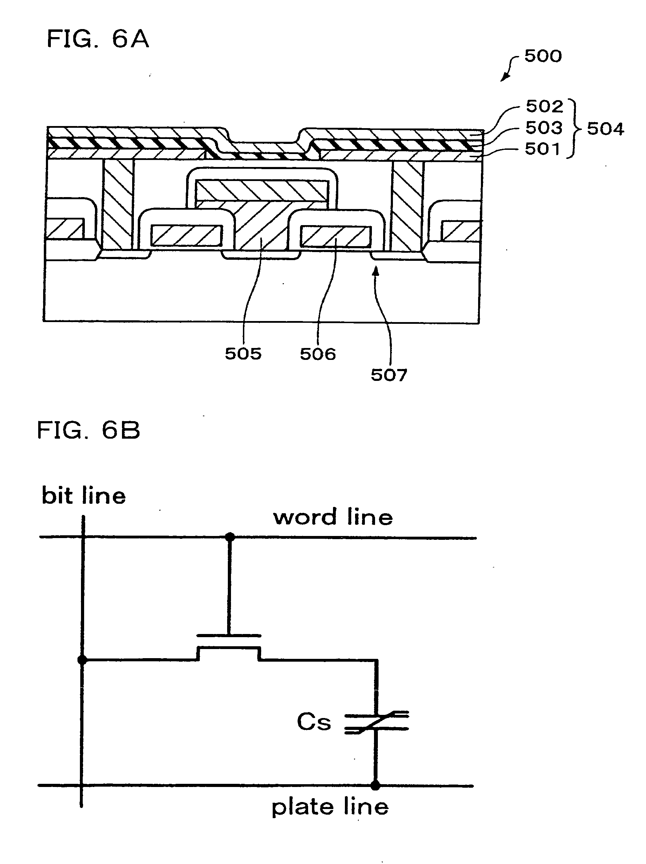

FIG. 6A is a structural diagram of a 1T1C type ferroelectric memory device 500 as a modification. FIG. 6B is an equivalent circuit diagram of the ferroelectric memory device 500.

As shown in FIG 6A, the ferroelectric memory device 500 is a memory device having a structure similar to that of a DRAM, and includes a capacitor 504 (1C) including a lower electrode 501, an upper electrode 502 connected with a plate line, and a ferroelectric film 503 according to the above-described embodiment, and a switch transistor element 507 (IT) including source/drain electrodes, one of which is connected with a data line 505, and a gate electrode 506 connected with a wordline. Since the 1T1C type memory allows high-speed writing and reading (100 ns or less) and written data does not volatilize, the 1T1C type memory is expected to replace an SRAM.

Examples of the embodiments of the invention are described above. However, the invention is not limited to the above-described embodiments. Various modifications and variations may be made within the scope of the invention.

### 4. Experimental example

An experimental example of the invention is described below.

A ferroelectric film according to one embodiment of the invention was formed by using a raw material solution described below.

A solution was prepared by mixing bismuth octylate and niobium octylate in a solvent such as n-butanol at a molar ratio of "bismuth octylate:niobium octylate = 1:1" together with 1.5 mol% of Si.

The above solution and dimethyl succinate were mixed to prepare a raw material solution. Dimethyl succinate was mixed in an amount of 0.5 mol/l for 1 mol/l of the metal element concentration of the raw material solution. The raw material solution was then sealed and allowed to stand at 90°C for 30 min. The raw material solution was then cooled to room temperature to cause esterification to sufficiently proceed.

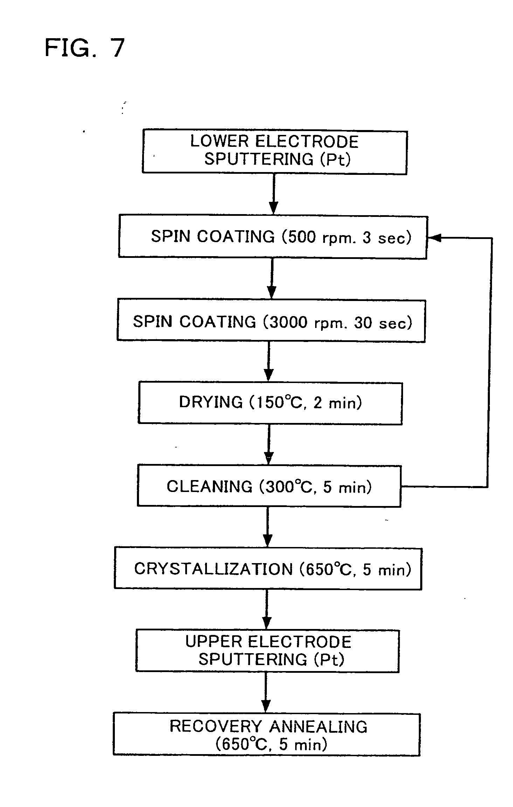

A sample was prepared by using the resulting solution according a method shown in FIG. 7.

Specifically, a platinum lower electrode was formed by using a sputtering method. The raw material solution was applied to the platinum substrate by using a spin coating method, and dried at 150 to 180°C (150°C) by using a hot plate to remove the alcohol. A cleaning heat treatment was performed at 300 to 350°C (300°C) by using a hot plate. The coating step, the drying treatment step, and the cleaning heat treatment step were arbitrarily performed a number of times (three times in total) to obtain a coating film having a desired thickness. The coating film was then subjected to crystallization annealing (sintering) to obtain a ferroelectric film sample having a thickness of 150 nm. The crystallization sintering was performed in an oxygen atmosphere at 650 to 700°C (650°C) by rapid thermal annealing (RTA). Then, a platinum upper electrode was formed by using a sputtering method, and recovery annealing was performed at 650 to 700°C (650°C) by RTA to obtain a ferroelectric capacitor sample (hereinafter may be called "capacitor sample").

The following characteristics were examined by using the resulting sample.

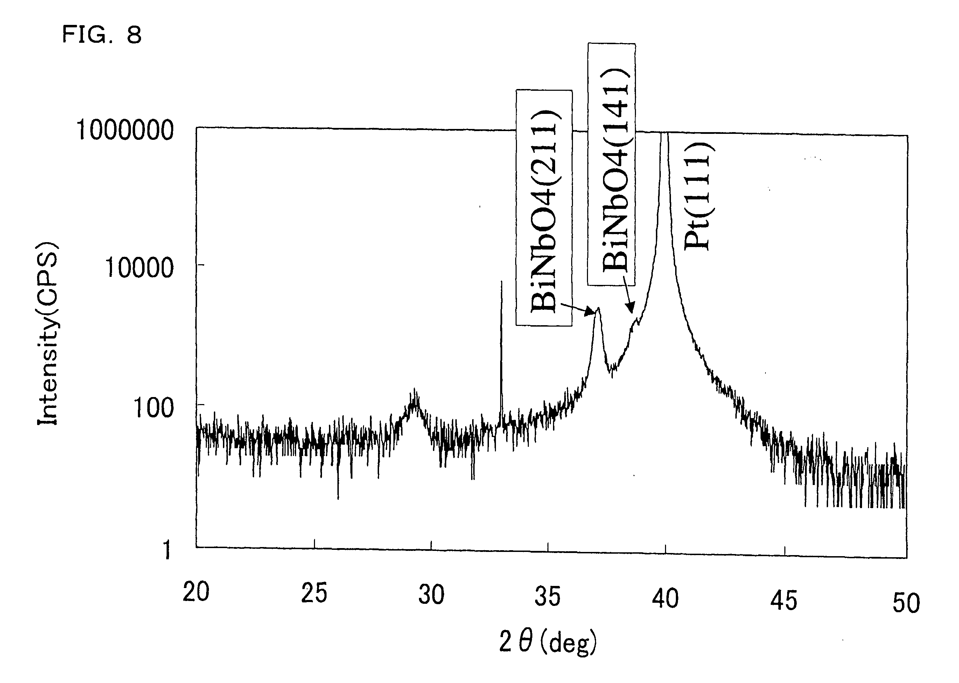

The crystallinity of the ferroelectric film sample was examined by X-ray diffraction analysis. FIG. 8 is a diagram showing the crystallinity of the ferroelectric film sample. As shown in FIG 8, (141) and (211) peaks attributed to BiNbO₄ were recognized so that it was confirmed that a crystal having a bismuth-layered perovskite structure was formed.

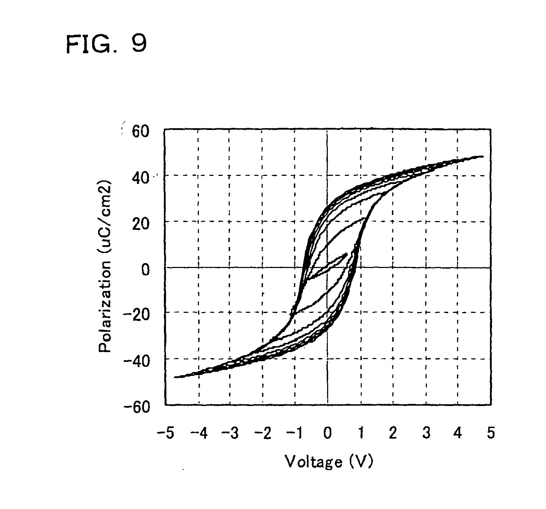

FIG. 9 is a hysteresis diagram of the capacitor sample. As shown in FIG 9, it was confirmed that each capacitor sample had excellent hysteresis characteristics.

Although only some embodiments of the invention have been described in detail above, those skilled in the art will readily appreciate that many modifications are possible in the embodiments without departing from the novel teachings and advantages of this invention. Accordingly, all such modifications are intended to be included within the scope of this invention.

## Claims

1. A ferroelectric film, comprising BiNbO₄.

2. The ferroelectric film as defined in claim 1,
wherein the BiNbO₄ has a Bi-layered perovskite structure.

3. The ferroelectric film as defined in claim 1 or 2, further comprising Si or Si and Ge.

4. A method of manufacturing a ferroelectric film, the method comprising:
(a) mixing a polycarboxylate containing niobium, a polycarboxylate containing bismuth, a polycarboxylic acid or a polycarboxylic acid ester, and an organic solvent; and
(b) applying the resulting mixed solution to a substrate and heat-treating the applied mixed solution to form a ferroelectric film including BiNbO₄.

5. A method of manufacturing a ferroelectric film, the method comprising:
(a) mixing a sol-gel raw material including a hydrolysis-condensation product of a metal alkoxide containing niobium, a sol-gel raw material including a hydrolysis-condensation product of a metal alkoxide containing bismuth, a polycarboxylic acid or a polycarboxylic acid ester, and an organic solvent, and causing the polycarboxylic acid or a polycarboxylic acid derived from the polycarboxylic acid ester to undergo esterification with the metal alkoxide containing niobium and the metal alkoxide containing bismuth to prepare a ferroelectric precursor composition; and
(b) applying the precursor composition to a substrate and heat-treating the applied precursor composition to form a ferroelectric film including BiNbO₄.

6. The method of manufacturing a ferroelectric film as defined in claim 4 or 5, wherein the organic solvent is an alcohol.

7. The method of manufacturing a ferroelectric film as defined in any one of claims 4 to 6,
wherein the step (a) includes mixing a sol-gel raw material containing Si or Si and Ge.

8. A ferroelectric raw material solution, comprising:
a polycarboxylate containing niobium;
a polycarboxylate containing bismuth;
a polycarboxylic acid or a polycarboxylic acid ester; and
an organic solvent.

9. A ferroelectric raw material solution, comprising:
a sol-gel raw material including a hydrolysis-condensation product of a metal alkoxide containing niobium;
a sol-gel raw material including a hydrolysis-condensation product of a metal alkoxide containing bismuth;
a polycarboxylic acid or a polycarboxylic acid ester; and
an organic solvent.

10. A ferroelectric capacitor, comprising the ferroelectric film as defined in any one of claims 1 to 3.

11. A ferroelectric memory, comprising the ferroelectric capacitor as defined in claim 10.
